# FASCICULE DE BREVET EUROPEEN

(11) **EP 2 992 558 B1**
(45) Date de publication et mention de la délivrance du brevet: **09.09.2020**
(21) Numéro de dépôt: 14718970.8
(22) Date de dépôt: 18.04.2014
(51) Int. Cl.: H01L 21/335, H01L 21/265

(54) **PROCEDE DE FORMATION D'UNE ZONE IMPLANTEE POUR UN TRANSISTOR A HETEROJONCTION DE TYPE NORMALEMENT BLOQUE**
VERFAHREN ZUR HERSTELLUNG EINES IMPLANTIERTEN BEREICHS FÜR EINEN NORMAL BLOCKIERTEN HETEROÜBERGANGSTRANSISTOR
METHOD FOR FORMING AN IMPLANTED AREA FOR A HETEROJUNCTION TRANSISTOR THAT IS NORMALLY BLOCKED

(30) Priorité: 30.04.2013 FR 1354000
(43) Date de publication de la demande: 09.03.2016
(73) Titulaire: Commissariat à l'Energie Atomique et aux Energies Alternatives, 75015 Paris (FR)
(72) Inventeur: MORVAN, Erwan, 38160 Montagne (FR)
(74) Mandataire: Guérin, Jean-Philippe
(86) Numéro de dépôt international: PCT/EP2014/058027
(87) Numéro de publication internationale: WO 2014/177407

(56) Documents cités:
- EP-A1- 2 455 964
- WO-A1-2010/038150
- US-A1- 2007 278 521
- US-A1- 2012 122 281
- MAOJUN WANG ET AL: "Improvement of the Off-State Breakdown Voltage With Fluorine Ion Implantation in AlGaN/GaN HEMTs", IEEE TRANSACTIONS ON ELECTRON DEVICES, IEEE SERVICE CENTER, PISACATAWAY, NJ, US, vol. 58, no. 2, 1 février 2011 (2011-02-01), pages 460-465, XP011343588, ISSN: 0018-9383, DOI: 10.1109/TED.2010.2091958
- LONG TAO ET AL: "High surface hole concentration p-type GaN using Mg implantation", BEIJING DAXUE XUEBAO ZERAN KEXUE BAN - ACTA SCIENTIARUMNATURALIUM UNIVERSITATIS PEKINENSIS, BEIJING DAXUE CHUBANSHE, BEIJING, CN, vol. 37, no. 5, 1 septembre 2001 (2001-09-01), pages 701-704, XP008166378, ISSN: 0479-8023

## Description

L'invention concerne les transistors de puissance, et en particulier les transistors de puissance à haute mobilité électronique, à hétérojonction faisant appel à des couches semi-conductrices de GaN.

De nombreuses applications électroniques nécessitent dorénavant un fonctionnement à des fréquences de plus en plus élevées. Ces applications ne sont pas limitées au marché des télécommunications. Des commutateurs dans des gammes de fréquences élevées sont également nécessaires dans l'électronique embarquée à destination de l'automobile et des transports terrestres, dans l'aéronautique, dans les systèmes médicaux ou dans des solutions domotiques par exemple. Ces applications nécessitent pour la plupart des commutateurs sous forte puissance (typiquement entre 500V et plusieurs kilovolts, avec des courants le plus souvent compris entre 10 et 200 A) fonctionnant dans des gammes de fréquences pouvant atteindre et même dépasser le megahertz.

Historiquement, des commutateurs hautes fréquences de puissance ont longtemps fait appel à des transistors à effet de champ basés sur un canal semi-conducteur (MOSFETs de puissance). Pour des fréquences plus faibles, les transistors à jonction (thyristors, IGBT ...) sont préférés car ils supportent des densités de courant plus élevées. Cependant, du fait de la tension de claquage relativement limitée de chacun de ces transistors, les applications de puissance nécessitent l'utilisation d'un grand nombre de transistors en série. Les pertes à travers ces transistors en série sont importantes, aussi bien en régime établi qu'en commutation.

Une alternative pour des commutateurs de puissance en hautes fréquences est l'utilisation de transistors à effet de champ à haute mobilité d'électrons (HEMT), également désignés par le terme de transistor à effet de champ à hétérostructure (HFET). Un tel transistor inclut la superposition de deux couches semi-conductrices ayant des bandes interdites différentes formant un puit de potentiel à leur interface. Des électrons sont confinés dans ce puits pour former un gaz bidimensionnel d'électrons. Pour des raisons de tenue en tension et en température, ces transistors seront choisis de façon à présenter une large bande d'énergie interdite.

Parmi les transistors HEMT à large bande d'énergie interdite (usuellement dénommée 'gap' en langue anglaise), les transistors à base de nitrure de gallium sont très prometteurs. Leur largeur de bande d'énergie interdite induit un champ électrique critique plus élevé comparé aux matériaux classiques de l'électronique (Si, SiGe, GaAs, InP), une vitesse de saturation élevée des porteurs et de bonnes stabilités thermique et chimique (permettant une utilisation dans des environnements difficiles). Le champ de claquage du nitrure de gallium (GaN) peut ainsi être supérieur à 2x10⁶ V/cm, ce qui permet aisément de réaliser des transistors compacts avec des tensions de claquage supérieures à 100 V (500 nm de GaN sont suffisants). De plus, de tels transistors permettent de très grandes densités de courant du fait de la très grande mobilité électronique et de la forte densité électronique dans le gaz d'interface.

Le nitrure de gallium présente une bande d'énergie interdite large de 3,39eV. De plus, des alliages ternaires tels que du AlGaN, InAlN ou InGaN peuvent aisément être réalisés à partir d'une machine à former du GaN par épitaxie. Un transistor HEMT à base de nitrure de gallium peut aussi être réalisé sur un substrat en silicium (qui est le substrat de base de l'industrie du semi-conducteur). Le transistor GaN Hemt a donc un coût de production beaucoup plus faible qu'un transistor à base de SiC par exemple. Même si un transistor à base de SiC présente également une large bande d'énergie interdite, des hétérojonctions peuvent difficilement être réalisés à partir de ce matériau, et il ne peut pas être réalisé sur substrat silicium standard, étant données les températures de croissance par épitaxie nécessaires, ce qui rend le coût de fabrication prohibitif et en limite fortement les applications.

Pour certaines applications, notamment en vue d'isoler un circuit en cas de dysfonctionnement d'un système de commande, on utilise des transistors du type normalement bloqué, c'est-à-dire que leur tension de seuil de commutation est positive, de sorte que le transistor reste bloqué en l'absence de signal de commande.

Du fait de la nature intrinsèquement conductrice de la couche de gaz d'électrons formée entre une source et un drain, il est technologiquement plus facile de réaliser un transistor à hétérojonction de type normalement passant. Cependant, plusieurs procédés de fabrication ont été développés en vue de former des transistors à hétérojonction de type normalement bloqué.

Le document MAOJUN WANG ET AL: "Improvement of the Off-State Breakdown Voltage With Fluorine Ion Implantation in AIGaN/GaN HEMTs",IEEE TRANSACTIONS ON ELECTRON DEVICES, IEEE SERVICE CENTER, PISACATAWAY, NJ, US, vol. 58, no. 2, 1 février 2011 (2011-02-01), pages 460-465, XP011343588,ISSN: 0018-9383, décrit l'implantation de fluor dans un HEMT.

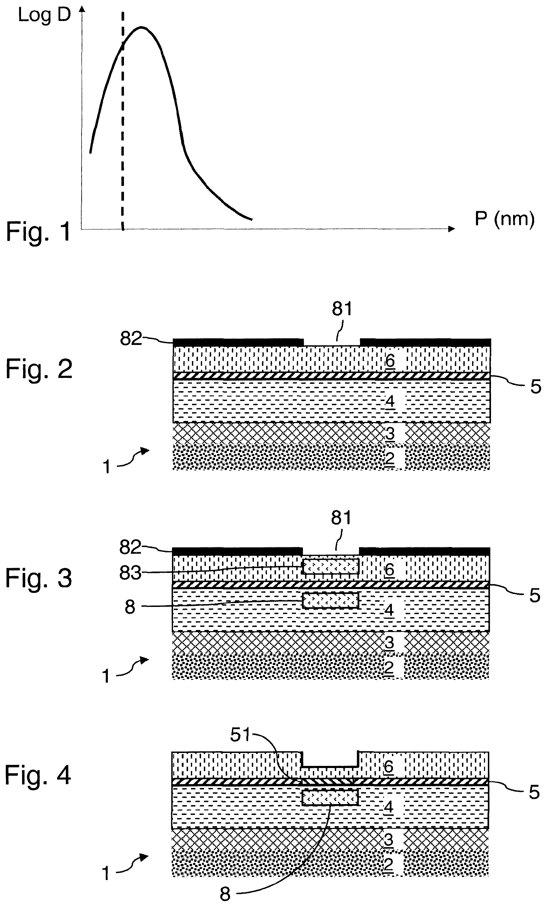

Selon une première approche, on réalise une couche binaire de nitrure de gallium GaN par épitaxie, on réalise ensuite une couche ternaire d'AlGaN par épitaxie pour former une couche de gaz d'électrons par hétérojonction à l'interface entre ces couches. On implante ensuite à haute énergie (plus de 100keV) des dopants de type P sous forme de magnésium, de façon à former une zone implantée à l'intérieur de la couche de GaN. Une haute énergie d'implantation est nécessaire pour atteindre une profondeur d'implantation satisfaisante. La zone implantée formée ayant une incidence sur la tension de seuil, la profondeur et la concentration du dopant doivent être définies avec le maximum de précision. Afin de contrôler précisément le profil de dopants, cette implantation est effectuée avec une inclinaison très précise par rapport à la normale à la couche d'AlGaN, afin d'éviter d'implanter selon un des axes d'implantation canalisée du matériau. L'implantation peut ainsi être ménagée à une profondeur contrôlée à quelques centaines de nm sous l'interface entre le GaN et l'AlGaN, du fait des interférences avec la structure cristalline. Un exemple de profil d'implantation est illustré à la figure 1 : le profil d'implantation présente ainsi une répartition sensiblement gaussienne dans la profondeur.

La zone implantée de magnésium est ensuite activée par un recuit à haute température, le magnésium se positionnant dans la maille cristalline du GaN en substitution de l'élément III. Une fois la zone implantée activée, le champ électrique généré par la zone implantée permet de créer une zone isolante (déplétée de porteurs) à sa verticale, à l'interface entre la couche de GaN et de la couche d'AlGaN. Ainsi, on déplète le gaz d'électrons au niveau de l'hétérojonction, jusqu'à ce qu'une tension de seuil positive soit appliquée.

L'étape d'implantation à haute énergie induit des défauts cristallins dans la structure de la couche de GaN et de la couche d'AlGaN. Ces défauts cristallins sont difficiles à éliminer. Ils perturbent l'activation du dopant implanté (et donc la tension de seuil du transistor) ainsi que la mobilité des électrons au niveau de l'hétérojonction. Les défauts cristallins résiduels peuvent aussi former des états électroniques dans la bande interdite du semi-conducteur et engendrer un phénomène de piégeage des porteurs qui perturbe le fonctionnement du transistor (Phénomène de résistance de conduction dynamique)

Selon une seconde approche, le document WO2005/070009 décrit un procédé de fabrication dans lequel :
- une première couche de GaN est formée par épitaxie ;
- la zone implantée à dopage de type P est formée à haute énergie dans la première couche de GaN ;
- une deuxième couche de GaN est formée par épitaxie sur la zone implantée et la première couche de GaN ;
- une couche d'AlGaN est formée par épitaxie sur la deuxième couche de GaN ;
- une grille est formée sur la couche d'AlGaN à l'aplomb de la zone implantée.

Le transistor ainsi obtenu présente cependant des inconvénients. En effet, la première couche de GaN comporte également les défauts cristallins avec les conséquences mentionnées précédemment.

Des transistors hybrides hétérojonction/MOSFET sont également connus. Leur procédé de fabrication inclut la formation d'une couche binaire de nitrure de gallium GaN par épitaxie, suivie de la formation d'une couche ternaire d'AlGaN par épitaxie pour former une couche de gaz d'électrons par hétérojonction à l'interface entre ces couches. On grave ensuite une tranchée de grille à travers la couche d'AlGaN jusque dans la couche de GaN. La couche de gaz d'électrons est donc interrompue au niveau de la gravure de grille. On implante ensuite à haute énergie (plus de 100keV) des dopants de type P sous forme de magnésium, de façon à former une zone implantée dans la couche de GaN au fond de la tranchée de grille. Une couche d'oxyde est ensuite déposée pour recouvrir les parois et le fond de la tranchée de grille. Un empilement est ensuite déposé dans la tranchée. On dispose ainsi d'un puits semi-conducteur à dopage de type P à l'aplomb de la grille. On dispose également de jonctions conductrices à travers la couche de gaz d'électrons entre le canal d'une part et la source et le drain d'autre part. L'étape d'implantation à haute énergie induit des défauts cristallins dans la zone d'implantation du magnésium de la couche de GaN.

L'invention vise à résoudre un ou plusieurs de ces inconvénients. L'invention porte ainsi sur un procédé de fabrication d'un transistor à hétérojonction tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est un exemple de diagramme d'implantation ionique selon une inclinaison garantissant une précision sur le profil d'implantation ;
- les figures 2 à 5 sont des vues en coupe d'un transistor à hétérojonction à effet de champ, durant différentes étapes d'un exemple de procédé de fabrication selon l'invention ;
- la figure 6 est une vue en perspective d'une structure cristalline hexagonale de GaN ;
- la figure 7 est un exemple de diagramme d'implantation ionique de magnésium à l'issue d'une étape du procédé de fabrication du transistor ;
- la figure 8 est un autre exemple de diagramme de la concentration de dopants à l'issue d'une autre étape du procédé de fabrication ;
- les figures 9 à 12 sont des vues en coupe d'un transistor à hétérojonction à effet de champ, durant différentes étapes d'un autre exemple de procédé de fabrication selon l'invention ;
- les figures 13 à 16 sont des vues en coupe d'un autre type de transistor à hétérojonction à effet de champ, durant différentes étapes d'un exemple de procédé de fabrication selon l'invention ;
- la figure 17 est un exemple de diagramme d'implantation ionique de fluor.

Les figures 2 à 5 sont des vues en coupe schématiques d'un transistor à hétérojonction à effet de champ 1, durant différentes étapes d'un exemple de procédé de fabrication selon l'invention.

À la figure 2, on dispose d'un transistor 1 en formation, comportant un substrat 2, une couche tampon 3 disposée sur le substrat 2, une première couche semi-conductrice 4 en nitrure de gallium GaN disposée sur la couche tampon 3, une deuxième couche semi-conductrice 6 de type III-V disposée sur la couche 4, et un masque 82 disposé sur la couche 6. Un gaz d'électrons est intrinsèquement formé par hétérojonction à l'interface entre la couche 6 et la couche 4. Dans un souci de lisibilité, le gaz d'électrons est illustré sous forme de couche 5 à l'interface entre la couche 4 et la couche 6. Une ouverture 81 est ménagée dans le masque 82.

Le substrat 2 peut être un isolant ou un semi-conducteur de type silicium intrinsèque ou dopé. Le substrat 2 est typiquement du silicium à orientation (111) utilisé préférentiellement comme détaillé ultérieurement. Le substrat 2 peut typiquement présenter une épaisseur de l'ordre de 650 µm à 1 mm.

La couche tampon 3 déposée sur le substrat 2 sert d'intermédiaire entre ce substrat et la première couche 4 de GaN, pour permettre une adaptation de maille entre le substrat 2 et cette couche 4 et pour contrôler les contraintes mécaniques dans cette couche 4.

La couche 4 peut typiquement présenter une épaisseur comprise entre 100nm et 5µm. La couche 4 peut être formée de façon connue en soi par épitaxie sur la couche tampon 3. L'épitaxie est réalisée de sorte que la couche 4 formée présente une structure cristalline hexagonale avec une orientation [0 0 0 1] formant une normale à la surface supérieure du substrat 2. L'utilisation d'un substrat 2 de silicium à orientation (111) favorise la croissance par épitaxie de la couche 4, du fait d'une meilleure adaptation des paramètres de maille.

La couche 6 est typiquement formée par épitaxie en phase vapeur sur la deuxième couche 4. La couche 6 est généralement désignée par le terme barrière. La couche 6 est typiquement un alliage ternaire de nitrure d'élément III, par exemple du AlGaN, ou un alliage binaire de nitrure d'élément III, par exemple du AlN. Une couche 6 en AlGaN est particulièrement appropriée pour la couche 4 en GaN, la formation de la couche 6 par épitaxie étant alors simplement réalisée en maintenant le transistor 1 dans une même machine, et en réalisant une épitaxie en introduisant un précurseur de l'aluminium en supplément dans le mélange gazeux par rapport aux conditions d'épitaxie de la couche 4. L'épitaxie d'une telle couche 6 en AlGaN est avantageusement réalisée de sorte que celle-ci présente une structure cristalline hexagonale avec une orientation [0 0 0 1] formant une normale à la surface supérieure du substrat 2. Les orientations [0 0 0 1] respectives de la couche 4 et 6 sont ainsi confondues. La couche 6 présente une épaisseur comprise entre 5nm et 40nm, par exemple de 25nm. Bien que non illustré, la couche 6 peut comprendre une couche de 1 à 3nm d'alliage binaire de nitrure d'élément III formée sur la couche 4, cette couche d'alliage binaire étant recouverte d'une autre couche d'alliage ternaire de nitrure d'élément III.

A la figure 3, une implantation de dopants est réalisée dans la couche 4 à travers l'ouverture 81. L'implantation est réalisée par implantation ionique de magnésium, de calcium, de zinc pour des dopants de type P, ou de fluor comme élément fortement électronégatif. Deux zones implantées à forte concentration sont formées durant cette implantation : une zone implantée 8 dans la couche 4 et une zone 83 implantée dans la couche 6. L'implantation ionique est réalisée selon l'orientation [0 0 0 1] de la structure cristalline des couches 4 et 6. Du fait de cette direction d'implantation, les ions atteignant la couche 4 sont des ions canalisés. Par des essais, on a pu constater qu'on obtenait une implantation canalisée pour une implantation ionique présentant une orientation avec un angle inférieur ou égal à 2°, de préférence un angle inférieur ou égal à 1,5°, et avantageusement un angle inférieur ou égal à 1 ° par rapport à l'orientation [0 0 0 1] de la structure cristalline des couches 4 et 6. Ainsi, on peut obtenir une implantation canalisée même avec une imprécision sur l'orientation de l'implantation ou même avec une imprécision par rapport à l'orientation [0 0 0 1] de la structure cristalline formée pour les couches 4 et 6.

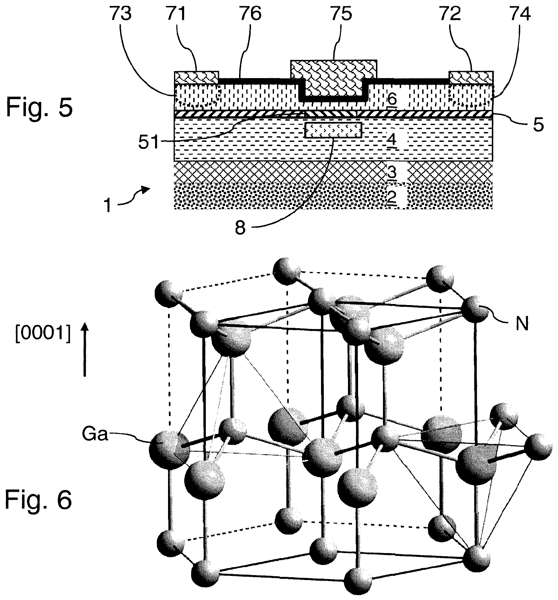

La figure 6 est une vue en perspective schématique de la structure cristalline hexagonale de la couche 4 de GaN. La structure cristalline du GaN forme comme des canaux cristallins dans lesquels l'interaction avec les ions implantés est minimale, permettant leur implantation sur une grande profondeur pour une énergie donnée. De plus, le GaN présente une densité atomique relativement élevée, induisant une forte densité atomique concentrée à la périphérie des canaux cristallins, ce qui favorise le guidage des ions canalisés.

Un tel mode d'implantation est ici utilisé alors qu'il est évité dans l'état de la technique du fait d'un manque de contrôle du profil d'implantation. Une telle implantation canalisée en profondeur est particulièrement favorable avec des ions de magnésium, de calcium, de zinc, ou de fluor : ces ions présentent un numéro atomique particulier qui conduit à une interaction réduite avec les électrons des atomes de la structure cristalline durant la traversée des canaux cristallins. L'implantation canalisée de tels ions réduit fortement la quantité de défauts cristallins dans la structure cristalline du GaN de la couche 4, par rapport à une implantation selon l'état de la technique. Pour une profondeur d'implantation donnée des ions, une énergie d'implantation relativement faible peut être utilisée. Une telle implantation altère également de façon moindre les propriétés de conduction de la couche de gaz d'électrons 5. L'utilisation d'ions de magnésium s'avère particulièrement avantageuse. En effet, pour une énergie d'implantation donnée, la profondeur d'implantation du magnésium avec une implantation canalisée est plusieurs dizaines de fois supérieure à la profondeur d'implantation avec une inclinaison d'implantation selon l'état de la technique.

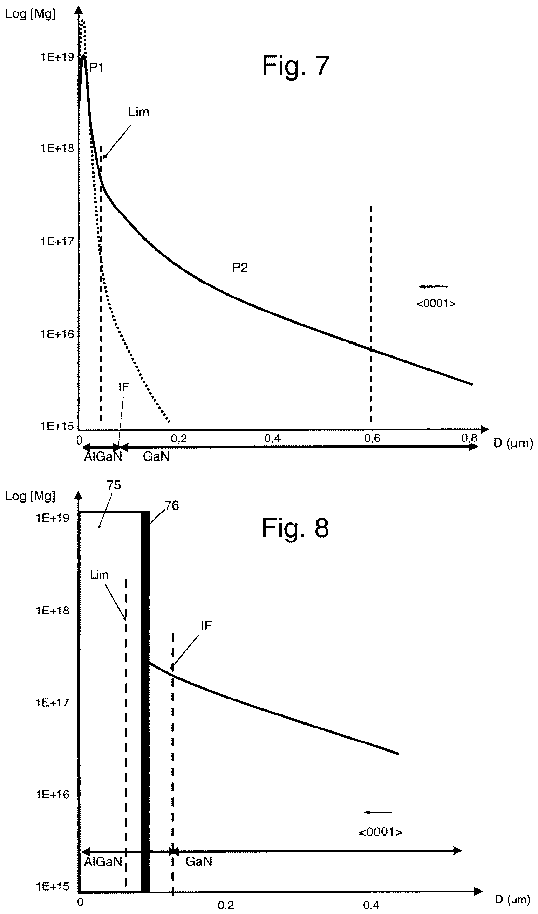

La figure 7 est un exemple de diagramme illustrant la concentration de dopants en magnésium en fonction de la profondeur, à l'issue de l'étape d'implantation, en fonction de l'angle par rapport à la direction [0 0 0 1] de la structure cristalline de la couche 4. L'implantation a ici été réalisée avec une énergie de 5keV.

La courbe en pointillés correspond à une implantation avec un angle de 7° par rapport à la direction [0 0 0 1] de la structure cristalline de la couche 4, correspondant à un procédé de l'état de la technique.

La courbe en trait plein correspond à une implantation avec un angle de 0° par rapport à la direction [0 0 0 1] de la structure cristalline de la couche 4, correspondant à une mise en œuvre de l'invention.

Avec la mise en œuvre selon l'invention, on réalise une implantation de type gaussienne dans une région P1 (ici sur une profondeur d'environ 40nm). Une partie de cette implantation peut être expliquée par une interaction d'une partie des ions avec les atomes de l'entrée de la structure cristalline (collisions à faible paramètre d'impact avec les atomes de la surface), par des défauts cristallins, par une couche d'oxyde natif, et par les vibrations thermiques des atomes du cristal. Cette implantation génère la zone implantée 83 dans la couche 6.

Une telle région P1 d'implantation peut être observée avec une énergie d'implantation comprise entre 1 et 10keV par exemple. Cette région d'implantation pourra correspondre sensiblement à l'épaisseur de la couche 6 en AlGaN (avec par exemple une profondeur du pic de la région P1 à 14nm pour 10keV) ou être d'une épaisseur inférieure à celle de la couche 6.

Plus en profondeur dans la région P1, la concentration d'implantation chute fortement lorsqu'on s'éloigne du pic. Plus en profondeur (ici au-delà de 40nm), on observe une région P2 débutant au niveau d'un point d'inflexion du diagramme, illustré par la référence Lim. La région P2 présente une décroissance progressive de la concentration de l'implantation. Par rapport à la dose totale de dopants introduite durant l'implantation, on observe que 30 à 40% sont implantés entre 40 et 600nm (zone délimitée par deux traits discontinus sur le diagramme). Une quantité non négligeable de dopants est donc implantée en profondeur dans la couche 4 malgré une énergie d'implantation relativement faible, et selon un profil aisé à contrôler. Dans l'exemple illustré, on a constaté une concentration de dopants non négligeable (typiquement supérieure ou égale à 5.10¹⁵ cm⁻³) jusqu'à une profondeur d'environ 50 fois la profondeur du pic de la région P1. Avantageusement, au moins 30% de la quantité des dopants implantés est répartie dans une région P2 dont l'épaisseur est au moins 3 fois celle de la région P1. Du fait d'une faible énergie d'implantation utilisable, l'implantation dans la couche 4 induit une quantité réduite de défauts cristallins.

La région P1 présente avantageusement une épaisseur inférieure ou égale à celle de la couche 6. La couche 5 (ici matérialisée par l'interface IF) est alors avantageusement disposée dans la zone P2.

Les concentrations respectives des régions P1 et P2 sont fonction de l'énergie et de la dose d'implantation ainsi que de la densité de défauts dans l'épitaxie, de la couche d'oxyde natif et de la température lors de l'implantation.

La zone implantée 8 ainsi formée présente avantageusement une épaisseur comprise entre 15 et 800 nm. La zone implantée 8 pourra présenter une concentration de dopant magnésium maximale comprise entre 10¹⁶ et 10¹⁹ cm⁻³. Le dopage parasite d'une couche GaN en dopants de type P est usuellement d'un niveau proche de 10¹⁵ cm⁻³. La concentration de dopants magnésium dans la zone implantée 8 est alors suffisamment élevée à proximité de l'interface IF pour avoir une influence sur la densité d'électrons au niveau de cette interface IF (déplétion pour l'état non passant) et suffisamment basse pour ne pas perturber la mobilité de ces électrons (état passant).

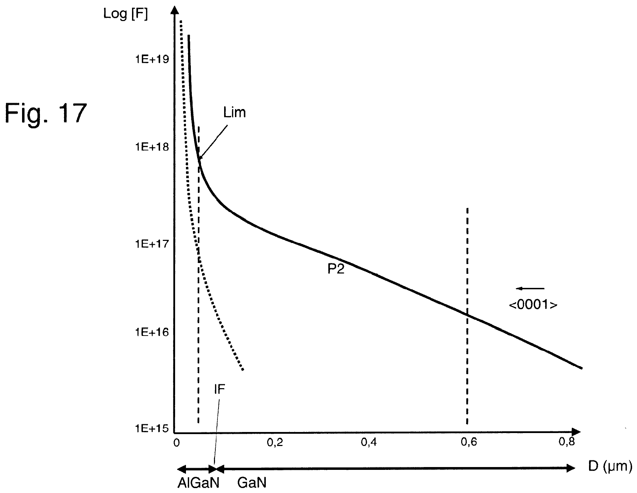

Des résultats similaires ont été obtenus pour l'implantation de Fluor : la figure 17 est un diagramme de résultats permettant de comparer l'implantation avec des angles de 0° (en trait plein) et 7° (en trait discontinu) par rapport à la direction [0 0 0 1] de la structure cristalline de la couche 4, avec une énergie d'implantation de 5keV. On constate une implantation canalisée avec une densité importante dans la couche 4 avec un angle d'implantation de 0°, au-delà d'une profondeur identifiée par Lim. La concentration de dopants implantée en deçà de la profondeur Lim est nettement plus importante avec une implantation avec un angle de 7° par rapport à la direction [0 00 1] de la structure cristalline de la couche 4.

A la figure 4, on a avantageusement procédé à une gravure de la couche 6 à l'aplomb de la zone implantée 8. La gravure est réalisée de façon à retirer la zone implantée 83 et à amincir l'épaisseur de la couche 6 à l'aplomb de la zone implantée 8. L'emplacement de la gravure correspond à la position au niveau de laquelle la grille de commande du transistor 1 doit être formée. La tranchée formée lors de la gravure permet de rapprocher la grille de la zone 51 pour réduire la population du gaz d'électron en réduisant l'effet de polarisation de la couche barrière (par ex :AlGaN). Cela permet de faciliter l'obtention du transistor normalement ouvert. La distance entre le fond de la tranchée et l'interface entre les couches 4 et 6 est avantageusement comprise entre 5 et 10nm. Le masque 82 est également retiré jusqu'à découvrir la face supérieure de la couche 6.

Une zone isolante 51 est formée dans la couche 5, à l'aplomb de la zone implantée 8. Cette zone 51 est rendue isolante par la présence du champ électrique généré par les dopants de la zone implantée 8 et par l'amincissement de la couche 6. Le transistor 1 est donc bloqué en l'absence de signal de commande appliqué sur la grille.

Une étape de recuit (à une température typiquement comprise entre 1000 et 1400°C pour du magnésium) est mise en œuvre et permet d'activer les dopants de la zone implantée 8 en permettant leur positionnement dans la structure cristalline de la couche 4, et reconstituer la structure cristalline des couches 4 et 6 face aux défauts résiduels induits par l'implantation.

Lorsque le dopant implanté est du fluor, on remplace l'étape de recuit par un simple réchauffage destiné à reconstituer la structure cristalline des couches 4 et 6 face aux défauts résiduels induits par l'implantation (réchauffage à une température typiquement comprise entre 400 et 800°C).

A la figure 5, on a réalisé de façon connue en soi une source 71, un drain 72 et une grille 75 au-dessus de la couche 6. Une couche d'isolant 76 est formée de façon connue en soi sur la couche 6. La grille 75 est formée sur la couche d'isolant 76, à l'intérieur de la tranchée. La couche 5 est destinée à assurer la conduction entre la source et le drain lorsque le transistor 1 est passant. Le potentiel de commande appliqué sur la grille 75 définit si le transistor 1 est bloqué ou passant. On peut prévoir que la grille 75 soit de divers types, par exemple de type Schottky ou MIS (pour Metal Insulated Semiconductors en langue anglaise), sans qu'il soit nécessaire d'altérer la structure du transistor 1.

Afin de favoriser la densité de courant de conduction, la source 71 et le drain 72 peuvent par exemple être connectées à la couche 5 (illustré par les jonctions 73 et 74). La connexion peut être réalisée de façon connue en soi par diffusion du métal de la source et du drain dans la couche 6 d'une part, et par effet tunnel avec la couche 5 d'autre part. La diffusion dans la couche 6 d'un métal de la source et du drain initialement déposé sur cette couche 6 est par exemple réalisée lors d'une étape de recuit. Un tel métal peut être du Ti ou de l'Al, présentant un travail de sortie réduit. Lors du recuit, le Ti réagit par exemple avec du GaN pour former du TiN. Une région fortement dopée de quelques nm d'épaisseur est obtenue, formant un contact ohmique par effet tunnel avec la couche 5. La couche 6 peut éventuellement être amincie au niveau de la source et du drain par gravure.

La figure 8 est un diagramme de la concentration de dopants à l'issue de l'étape de formation de la grille 75. La zone implantée 83 correspondant à l'implantation gaussienne est remplacée pour l'essentiel par la grille 75 et l'isolant 76.

Le procédé de fabrication peut bien entendu être mis en œuvre de façon différente. L'implantation peut par exemple être réalisée préalablement à la formation de la grille, après la formation d'une couche de passivation.

On peut également envisager de réaliser l'implantation canalisée dans la couche de GaN 4, puis former un complément de la couche 4 par épitaxie, puis effectuer la formation de la couche 6 par épitaxie.

On peut également envisager de réaliser l'implantation dans la couche GaN 4, de réaliser le retrait de la partie correspondant à l'implantation gaussienne (par gravure, ou par sublimation dans l'enceinte d'épitaxie) alors utilisée comme couche sacrificielle, puis de procéder au dépôt de la couche 6, afin de ne conserver que l'implantation canalisée dans la zone implantée 8 sous la zone 51.

Au fur et à mesure de l'implantation, il y a accumulation de défauts dans la structure cristalline. L'implantation canalisée est limitée par l'apparition des défauts cristallins qui perturbent la régularité des canaux cristallins. Ces perturbations induisent une limite supérieure de concentration d'ions implantés. Cette limite supérieure doit être supérieure à la concentration de dopants dans la zone implantée 8.

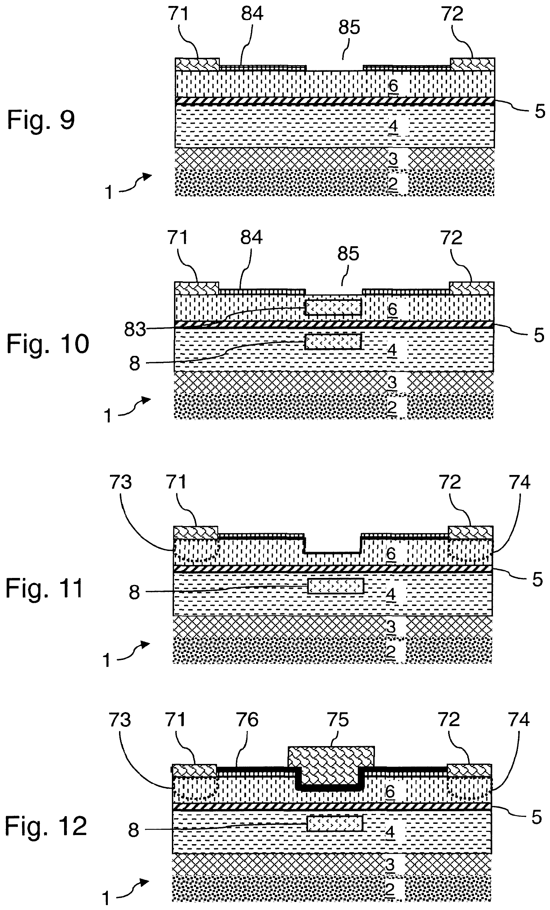

Les figures 9 à 12 sont des vues en coupe schématiques d'un transistor à hétérojonction à effet de champ 1, durant différentes étapes d'un autre exemple de procédé de fabrication selon l'invention.

À la figure 9, on dispose d'un transistor en formation 1, comportant un substrat 2, une couche tampon 3 disposée sur le substrat 2, une première couche semi-conductrice 4 en nitrure de gallium GaN disposée sur la couche tampon 3, une deuxième couche semi-conductrice 6 de type III-V disposée sur la couche 4, et un masque 84 disposé sur la couche 6. Un gaz d'électrons est intrinsèquement formé par hétérojonction à l'interface entre la couche 6 et la couche 4, et illustré sous forme de couche 5 à l'interface entre la couche 4 et la couche 6. Une source 71 et un drain 72 sont formés sur la couche 6. Une couche diélectrique de passivation 84 est également formée sur la couche 6. Une ouverture 85 est ménagée dans la couche de passivation 84.

Le substrat 2 est typiquement du silicium à orientation (111) utilisé préférentiellement. La couche tampon 3 déposée sur le substrat 2 sert d'intermédiaire entre ce substrat 2 et la première couche 4 de GaN. La couche 4 peut être formée de façon connue en soi par épitaxie sur la couche tampon 3. La couche 4 formée présente une structure cristalline hexagonale avec une orientation [0 0 0 1] formant une normale à la surface supérieure du substrat 2.

La couche 6 est typiquement un alliage ternaire de nitrure d'élément III, par exemple du AlGaN, présentant une orientation [0 0 0 1] formant une normale à la surface supérieure du substrat 2.

A la figure 10, une implantation de dopants de type P ou d'ion fortement électronégatif est réalisée dans la couche 4 à travers l'ouverture 85. L'implantation est réalisée par implantation ionique de magnésium, de calcium de zinc, ou de Fluor. Une zone implantée 8 est ainsi formée dans la couche 4 et la zone implantée 83 est formée dans la couche 6. L'implantation ionique est réalisée selon l'orientation [0 0 0 1] de la structure cristalline de la couche 4. Du fait de cette direction d'implantation, l'implantation des dopants dans la couche 4 est du type implantation canalisée.

A la figure 11, on a avantageusement procédé à une gravure de la couche 6 à l'aplomb de la zone implantée 8. La gravure est réalisée de façon à retirer la zone implantée 83 et à amincir l'épaisseur de la couche 6 à l'aplomb de la zone implantée 8. La distance entre le fond de la tranchée et l'interface entre les couches 4 et 6 est avantageusement comprise entre 5 et 10nm. La zone isolante 51 est formée dans la couche 5, à l'aplomb de la zone implantée 8. Une étape de recuit est mise en œuvre (par exemple à une température comprise entre 1200 et 1400°C). La source 71 et le drain 72 peuvent par exemple être connectées à la couche 5 (illustré par les jonctions 73 et 74) par diffusion du métal de la source et du drain dans la couche 6 lors du recuit d'une part, et par effet tunnel avec la couche 5 d'autre part.

A la figure 12, on a réalisé de façon connue en soi une couche diélectrique 76 et une grille 73 au-dessus de la couche diélectrique 76.

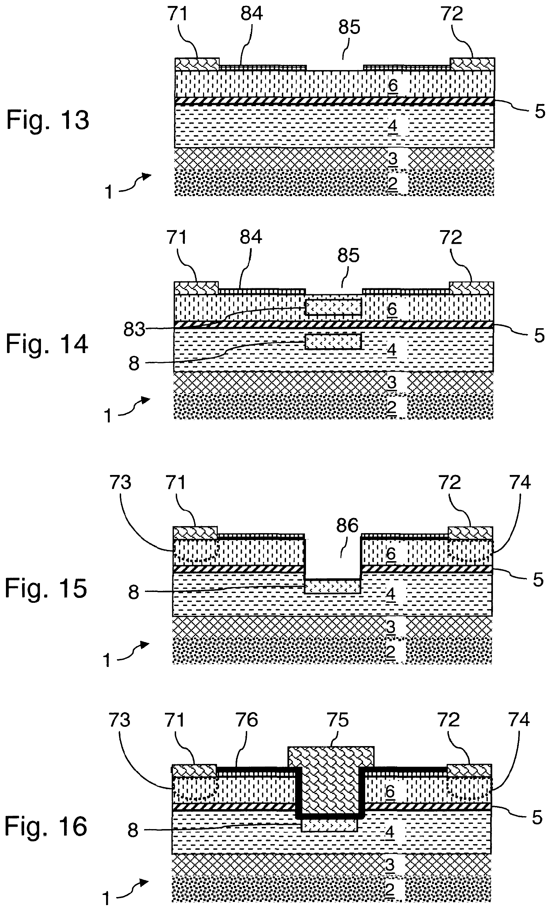

Les figures 13 à 16 sont des vues en coupe schématiques d'un transistor à effet de champ 1 hybride hétérojonction/MOSFET, durant différentes étapes d'un exemple de procédé de fabrication selon l'invention. Le transistor 1 est dit hybride car il comporte un canal à jonction de type semi-conductrice et des jonctions entre ce canal et la source et le drain avec une conduction par une couche de gaz d'électrons.

À la figure 13, on dispose d'un transistor en formation 1, comportant un substrat 2, une couche tampon 3 disposée sur le substrat 2, une première couche semi-conductrice 4 en nitrure de gallium GaN disposée sur la couche tampon 3 et une deuxième couche semi-conductrice 6 de type III-V disposée sur la couche 4. Un gaz d'électrons est intrinsèquement formé par hétérojonction à l'interface entre la couche 6 et la couche 4, et illustré sous forme de couche 5 à l'interface entre la couche 4 et la couche 6. Une source 71 et un drain 72 sont formés sur la couche 6. Une couche diélectrique de passivation 84 est également formée sur la couche 6. Une ouverture 85 est ménagée dans la couche de passivation 84.

Le substrat 2 est typiquement du silicium à orientation (111) utilisé préférentiellement. La couche tampon 3 déposée sur le substrat 2 sert d'intermédiaire entre ce substrat 2 et la première couche 4 de GaN. La couche 4 peut être formée de façon connue en soi par épitaxie sur la couche tampon 3. La couche 4 formée présente une structure cristalline hexagonale avec une orientation [0 0 0 1] formant une normale à la surface supérieure du substrat 2.

La couche 6 est typiquement un alliage ternaire de nitrure d'élément III, par exemple du AlGaN, présentant une orientation [0 0 0 1] formant une normale à la surface supérieure du substrat 2.

A la figure 14, une implantation de dopants de type P est réalisée dans la couche 4 à travers l'ouverture 85. L'implantation est réalisée par implantation ionique de magnésium, de calcium ou de zinc. Une zone implantée 8 est ainsi formée dans la couche 4 et une zone implantée 83 est formée dans la couche 6. L'implantation ionique est réalisée selon l'orientation [0 0 0 1] de la structure cristalline de la couche 4. Du fait de cette direction d'implantation, l'implantation des dopants dans la couche 4 est du type implantation canalisée.

A la figure 15, on a procédé à une gravure à travers la couche 6 et jusque dans la couche 4, à l'aplomb de la zone implantée 8. La tranchée 86 formée par cette gravure s'étend avantageusement jusque dans la zone implantée 8. La couche de gaz d'électrons 5 est donc interrompue au niveau de cette tranchée.

Une étape de recuit est mise en œuvre (par exemple à une température comprise entre 1000 et 1400°C). La source 71 et le drain 72 peuvent par exemple être connectées à la couche 5 (illustré par les jonctions 73 et 74) par diffusion du métal de la source et du drain dans la couche 6 lors du recuit d'une part, et par effet tunnel avec la couche 5 d'autre part.

A la figure 16, on a déposé une couche diélectrique 76 recouvrant les parois et le fond de la tranchée 86 et une grille 73 au-dessus de la couche diélectrique 76. Un empilement de grille 75 est ensuite déposé de façon connue en soi sur la couche diélectrique 76 et dans la tranchée.

Le transistor 1 comporte ainsi un canal formé dans la zone implantée 8 à l'aplomb de la grille 75. La conduction dans ce canal est donc établie selon un effet semi-conducteur, en fonction du champ appliqué par la grille 75. Une faible résistance est obtenue à l'état passant du transistor 1, du fait d'une conduction dans la couche de gaz d'électrons 5 entre le canal et la source 71 et le drain 72.

## Revendications

1. Procédé de fabrication d'un transistor (1) à hétérojonction, comprenant les étapes de :
- formation d'une zone implantée (8) par implantation ionique de magnésium, de calcium, de zinc ou de fluor dans une première couche semi-conductrice de nitrure de gallium (4) à structure cristalline hexagonale, ladite implantation ionique étant réalisée selon l'orientation [0 0 0 1] de cette structure cristalline ;
- formation d'une deuxième couche semi-conductrice (6) sur la première couche semi-conductrice de façon à former une couche de gaz d'électrons (5) à l'interface entre les première et deuxième couches ;
- formation d'une grille de commande (75) au-dessus de la deuxième couche conductrice (6) à l'aplomb de la zone implantée (8).

2. Procédé selon la revendication 1, comprenant une étape de recuit d'activation de la zone implantée (8).

3. Procédé selon la revendication 1 ou 2, dans lequel ladite première couche (4) est ménagée sur un substrat de silicium (2) présentant une orientation cristallographique (1 1 1).

4. Procédé selon l'une quelconque des revendications précédentes, dans lequel l'énergie d'implantation ionique est comprise entre 1 et 10 keV.

5. Procédé selon l'une quelconque des revendications précédentes, dans lequel ladite étape de formation de la deuxième couche semi-conductrice (6) inclut la croissance de cette couche par épitaxie.

6. Procédé selon l'une quelconque des revendications précédentes, dans lequel ladite étape d'implantation ionique est précédée de ladite étape de formation de la deuxième couche semi-conductrice (6).

7. Procédé selon la revendication 6, dans lequel ladite deuxième couche semi-conductrice (6) présente une structure cristalline hexagonale, ladite étape d'implantation étant réalisée selon l'orientation [0 0 0 1] de cette structure cristalline.

8. Procédé selon la revendication 6 ou 7, dans lequel ladite deuxième couche semi-conductrice (6) formée est un alliage binaire de nitrure d'élément III.

9. Procédé selon la revendication 6 ou 7, dans lequel ladite deuxième couche semi-conductrice (6) formée est un alliage ternaire de nitrure d'élément III.

10. Procédé selon l'une quelconque des revendications précédentes, dans lequel ladite formation d'une zone implantée dans première couche semi-conductrice induit un pic de densité d'implantation avec une répartition gaussienne selon l'épaisseur dans une zone de ladite deuxième couche semi-conductrice.

11. Procédé selon la revendication 10, comprenant une étape de retrait de ladite zone de ladite deuxième couche semi-conductrice présentant un pic de densité d'implantation avec une répartition gaussienne.

12. Procédé selon l'une quelconque des revendications précédentes, dans lequel la zone implantée formée dans la première couche semi-conductrice présente une densité de magnésium comprise entre 10¹⁶ et 10¹⁹ cm⁻³ sur une épaisseur au moins égale à 15 nm en partant de l'interface entre les première et deuxième couches semi-conductrices.

13. Procédé selon l'une quelconque des revendications précédentes, dans lequel la zone implantée formée dans la première couche semi-conductrice inclut au moins 30% de la quantité totale de dopants introduite durant l'implantation.

## Patentansprüche

1. Verfahren zur Herstellung eines Heteroübergangstransistors (1), das die folgenden Schritte aufweist:
- Bilden einer implantierten Zone (8) durch Ionenimplantation von Magnesium, Calcium, Zink oder Fluor in eine erste Halbleiterschicht aus Galliumnitrid (4) mit hexagonaler Kristallstruktur, wobei die Ionenimplantation gemäß der Orientierung [0 0 0 1] dieser Kristallstruktur ausgeführt wird;
- Bilden einer zweiten Halbleiterschicht (6) auf der ersten Halbleiterschicht, um eine Schicht aus Elektronengas (5) an der Grenzfläche zwischen der ersten und der zweiten Schicht zu bilden;
- Bilden eines Steuergitters (75) über der zweiten Halbleiterschicht (6) direkt über der implantierten Zone (8).

2. Verfahren nach Anspruch 1, das einen Schritt zum Aktivierungstempern der implantierten Zone (8) aufweist.

3. Verfahren nach Anspruch 1 oder 2, wobei die erste Schicht (4) auf einem Siliziumsubstrat (2) mit einer kristallographischen Orientierung (1 1 1) angeordnet ist.

4. Verfahren nach einem der vorhergehenden Ansprüche, wobei die Energie der Ionenimplantation zwischen 1 und 10 keV liegt.

5. Verfahren nach einem der vorhergehenden Ansprüche, wobei der Schritt des Bildens der zweiten Halbleiterschicht (6) das Züchten dieser Schicht durch Epitaxie aufweist.

6. Verfahren nach einem der vorhergehenden Ansprüche, wobei dem Schritt der Ionenimplantation der Schritt des Bildens der zweiten Halbleiterschicht (6) vorausgeht.

7. Verfahren nach Anspruch 6, wobei die zweite Halbleiterschicht (6) eine hexagonale Kristallstruktur aufweist und der Implantationsschritt gemäß der Orientierung [0 0 0 1] dieser Kristallstruktur ausgeführt wird.

8. Verfahren nach Anspruch 6 oder 7, wobei die gebildete zweite Halbleiterschicht (6) eine binäre Legierung aus Element-III-Nitrid ist.

9. Verfahren nach Anspruch 6 oder 7, wobei die gebildete zweite Halbleiterschicht (6) eine ternäre Legierung aus Element-III-Nitrid ist.

10. Verfahren nach einem der vorhergehenden Ansprüche, wobei das Bilden einer in die erste Halbleiterschicht implantierten Zone einen Peak der Implantationsdichte mit einer Gaußschen Verteilung gemäß der Dicke in einer Zone der zweiten Halbleiterschicht induziert.

11. Verfahren nach Anspruch 10, das einen Schritt zum Entfernen der Zone von der zweiten Halbleiterschicht aufweist, die einen Peak der Implantationsdichte mit einer Gaußschen Verteilung aufweist.

12. Verfahren nach einem der vorhergehenden Ansprüche, wobei die in der ersten Halbleiterschicht gebildete implantierte Zone eine Magnesiumdichte zwischen 10¹⁶ und 10¹⁹ cm⁻³ über eine Dicke von mindestens 15 nm ausgehend von der Grenzfläche zwischen der ersten und der zweiten Halbleiterschicht aufweist.

13. Verfahren nach einem der vorhergehenden Ansprüche, wobei die in der ersten Halbleiterschicht gebildete implantierte Zone mindestens 30 % der Gesamtmenge an Dotierstoffen enthält, die während der Implantation eingeführt werden.

## Claims

1. Heterojunction transistor (1) fabrication process, comprising the steps of:
- forming an implanted zone (8) by ion implantation of magnesium, calcium, zinc or fluorine in a first semiconductor layer (4) of gallium nitride of hexagonal crystal structure, said ion implantation being carried out in line with the [0001] direction of this crystal structure;
- forming a second semiconductor layer (6) on the first semiconductor layer so as to form an electron gas layer (5) at the interface between the first and second layers; and
- forming a control gate (75) above the second conductive layer (6) plumb with the implanted zone (8).

2. Process according to Claim 1, comprising a step of activation annealing of the implanted zone (8).

3. Process according to Claim 1 or 2, in which said first layer (4) is arranged on a silicon substrate (2) having a (111) crystal orientation.

4. Process according to any one of the preceding claims, in which the ion implantation energy is comprised between 1 and 10 keV.

5. Process according to any one of the preceding claims, in which said step of forming the second semiconductor layer (6) includes growing this layer by epitaxy.

6. Process according to any one of the preceding claims, in which said step of ion implantation is preceded by said step of forming the second semiconductor layer (6).

7. Process according to Claim 6, in which said second semiconductor layer (6) has a hexagonal crystal structure, said implantation step being carried out in line with the [0001] direction of this crystal structure.

8. Process according to Claim 6 or 7, in which said second semiconductor layer (6) formed is a binary group-III nitride alloy.

9. Process according to Claim 6 or 7, in which said second semiconductor layer (6) formed is a ternary group-III nitride alloy.

10. Process according to any one of the preceding claims, in which said step of forming of an implanted zone in the first semiconductor layer induces an implantation density peak with a Gaussian distribution thicknesswise in a zone of said second semiconductor layer.

11. Process according to Claim 10, comprising a step of removing said zone of said second semiconductor layer having an implantation density peak with a Gaussian distribution.

12. Process according to any one of the preceding claims, in which the implanted zone formed in the first semiconductor layer has a magnesium density comprised between 10¹⁶ and 10¹⁹ cm⁻³ over a thickness at least equal to 15 nm starting from the interface between the first and second semiconductor layers.

13. Process according to any one of the preceding claims, in which the implanted zone formed in the first semiconductor layer includes at least 30% of the total amount of dopant introduced during the implantation.
